# EUROPEAN PATENT APPLICATION

(11) **EP 1 226 921 A2**
(43) Date of publication of application: **31.07.2002**
(21) Application number: 02250351.0
(22) Date of filing: 18.01.2002
(51) Int. Cl.: B29C 45/66, H01L 21/00

(54) **Mechanism opening and closing a die of a resin seal apparatus**

(30) Priority: 30.01.2001 JP 2001020862
(71) Applicant: Towa Corporation, Kyoto (JP)
(72) Inventor: Amakawa, Tsuyoshi, c/o Towa Corporation, Kyoto-shi, Kyoto (JP)
(74) Representative: Roberts, David Leslie

(57) **Abstract**

A die opening and closing mechanism includes a bottom die block (1) fixed to a lower plate (2), a top die block (3) fixed to an upper plate (4), a bottom plate (6) integrally linked to the upper plate (4), a tie bar (7) provided to slide the lower plate (2), the upper plate (4) and the bottom plate (6), a mechanism (10) driving the lower plate (2), a link mechanism (11) connecting the bottom plate (6) and the lower plate (2) together and reversing in direction a driving force imparted for the lower plate (2), and transferring it to the bottom plate (6), and a pinch roller (19) fixed to a base (9) via attachment (20, 21). The pinch roller (19) fixed independent from the die allows the wired base material (17) to keep a position, in height, invariable whether the die is opened or closed. The wired base material (17) can thus have a loop (22) minimized. The die opening and closing mechanism can thus minimize the loop of the wired base material (17) to provide a wire free of distortion and accommodate the wired base material (17) large in thickness, and also provide a miniaturized apparatus.

## Description

### BACKGROUND OF THE INVENTION

### Field of the Invention

The present invention relates generally to mechanisms opening and closing dies of resin seal apparatuses employed to seal electronic components with resin, and particularly to die opening and closing mechanisms using a lead frame, a tape for tape automated bonding (TAB), hereinafter referred to as wired base material, and the like which are fed continuously.

### Description of the Background Art

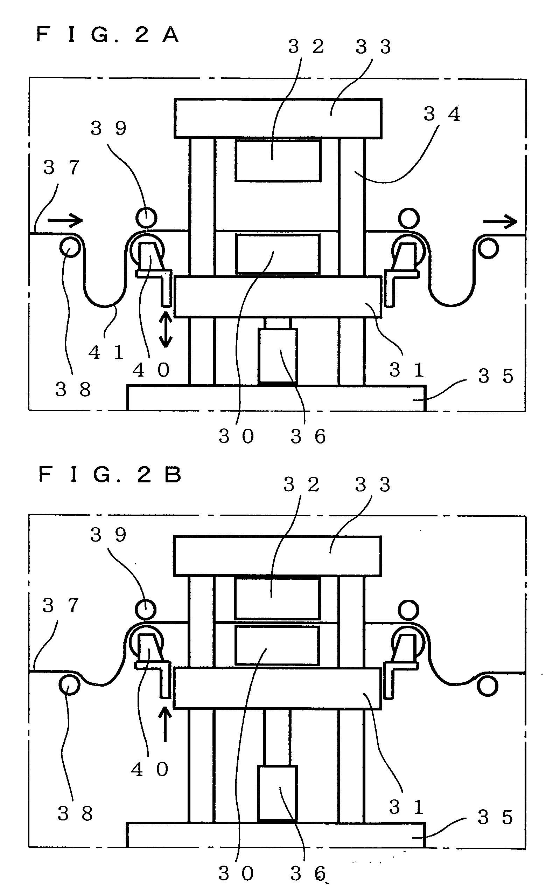

A conventional die opening and closing mechanism will be described with reference to Figs. 2A and 2B. Figs. 2A and 2B show the conventional die opening and closing mechanism opened and closed, respectively, as seen in a front view.

With reference to Fig. 2A, a bottom die block 30 is a movable die block attached to a lower plate 31, and a top die block 32 is a fixed die block attached to an upper plate 33. A tie bar 34 is a member linking upper plate 33 and a base 35 and also allowing lower plate 31 to slide.

A driving mechanism 36 is provided for example in the form of a hydraulic cylinder and moves lower plate 31 upward and downward.

A wired base material 37 is formed lengthy and also has an electronic component already packaged thereon and wired. Wired base material 37 is continuously fed from a wire bonder (not shown) provided on a left hand, as seen in the figure, through a guide roller 38 and right and left, horizontally positioned pinch rollers 39 successively to a resin seal die.

Right and left pinch rollers 39 are fixed to lower plate 31 via an attachment 40.

When bottom die block 30 is moved and thus spaced from top die block 32, as predetermined, and the die is thus opened, the top and bottom die blocks can have their surfaces cleaned and a resin tablet can be introduced into a resin supplying portion (not shown) of bottom die block 30.

The conventional die opening and closing mechanism, as shown in Fig. 2B, has lower plate 31 moving upward in closing the die. This elevates right and left pinch rollers 39 and wired base material 37. Accordingly the elevation needs to be allowed for. To do so, wired base material 37 needs to be loosened before the die is closed. As such, wired base material 37 has a loop 41 when the die is opened, as shown in Fig. 2A.

Thus, for the conventional die opening and closing mechanism, wired base material 37 needs to have loop 41 when the die is opened.

This may result in wired base material 37 having a pin experiencing stress which in turn deforms a wire.

Furthermore if the wired base material has a large thickness it has large stiffness and is thus difficult to accommodate.

Furthermore, to overcome these disadvantages, the loop needs to have an increased radius of curvature and the resin seal apparatus thus cannot be miniaturized.

### SUMMARY OF THE INVENTION

The present invention contemplates a die opening and closing mechanism capable of allowing a wired base material to have a loop minimized to prevent deformation of a wire and accommodate a wired base material large in thickness, and also provide a miniaturized resin seal apparatus.

To achieve the above object the present invention provides a die opening and closing mechanism for use in a seal apparatus sealing with resin an electronic component attached to a wired base material, including: a die set formed of opposite die blocks; a mechanism moving each of the die blocks upward and downward; and a mechanism transporting the wired base material to a space provided between the die blocks, wherein the transporting mechanism is provided to be independent from the die set.

The transport mechanism provided independent from the die set can keep wired base material 37 to have an invariable position as seen in a direction of height, whether each die block moves upward or downward.

In accordance with the present invention a lengthy, wired base material continuously fed can have a minimized loop. Thus the present invention can have a superior, practical effect that it can provide a die opening and closing mechanism capable of providing a wire free of deformation and accommodating a wired base material large in thickness and also allowing a resin seal apparatus to be miniaturized.

Furthermore in the present die opening and closing mechanism as described above the mechanism for upward and downward movement has a mechanism driving one of the die blocks in a predetermined direction and a mechanism transferring to the other die block a driving force imparted by the driving mechanism to one die block, wherein when one die block is driven in the predetermined direction the transferring mechanism drives the other die block in the opposite direction to open and close the die set.

Thus one and the other die blocks forming a die set can be driven simultaneously by a driving mechanism to open and close the die. Thus when the die is opened the die blocks can be spaced from each other, as predetermined, as required for example for cleaning the die.

The foregoing and other objects, features, aspects and advantages of the present invention will become more apparent from the following detailed description of the present invention when taken in conjunction with the accompanying drawings.

### BRIEF DESCRIPTION OF THE DRAWINGS

In the drawings:
Figs. 1A and 1B show a mechanism opening and closing a die of a resin seal apparatus in accordance with the present invention opened and closed, respectively, as seen in a front view; and
Figs. 2A and 2B show a conventional die opening and closing mechanism opened and closed, respectively, as seen in a front view.

### DESCRIPTION OF THE PREFERRED EMBODIMENTS

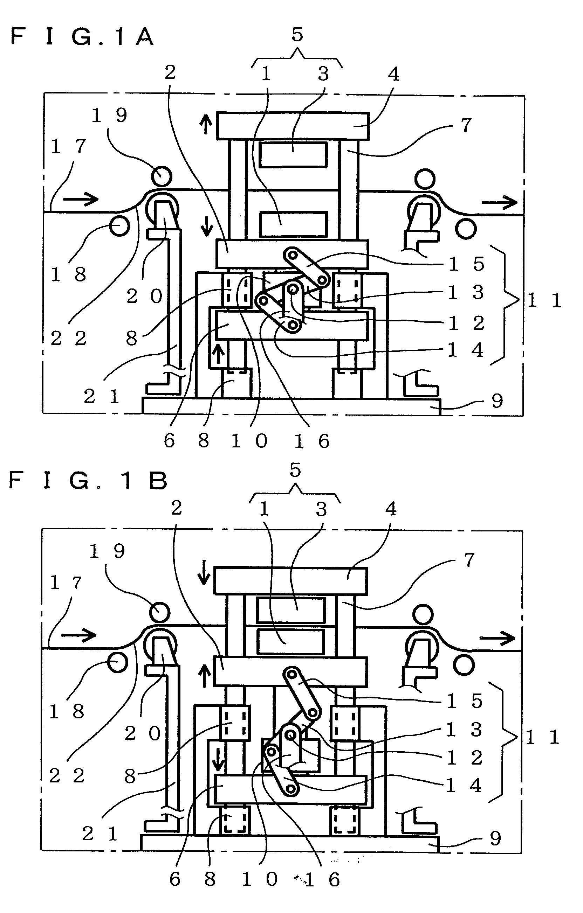

The present invention provides a die opening and closing mechanism, as will be described hereinafter with reference to Figs. 1A and 1B.

Figs. 1A and 1B show a mechanism opening and closing a die of a resin seal apparatus in accordance with the present invention opened and closed, respectively, as seen in a front view.

With reference to Fig. 1A, the die includes a movable, bottom die block 1 attached to a lower plate 2, and a movable, top die block 3 attached to an upper plate 4. Top and bottom die blocks 1 and 3 together form a die set 5 for resin-sealing.

A bottom plate 6 is a movable member integrally linked by a tie bar 7 to an upper plate 4.

Tie bar 7 is a member fitted to lower plate 2 and a guide 8 and allowing lower plate 2 itself to slide along tie bar 7 and also allowing the integrally linked upper plate 4 and bottom plate 6 to slide along guide 8.

Guide 8 is a member fixed to a base 9 and guiding tie bar 7 when tie bar 7 moves upward and downward together with upper plate 4 and bottom plate 6. Base 9 is a base member forming a base of the body of the resin seal apparatus.

A driving mechanism 36 is provided for example in the form of a hydraulic cylinder and moves lower plate 2 upward and downward.

Bottom and lower plates 6 and 2 are connected together by a pair of opposite link mechanisms 11. In the figure, only the frontward one of mechanisms 11 is shown.

Link mechanism 11 transfers to bottom plate 6 a driving force imparted to lower plate 2 and it is configured of a pivot 12, a bar 13 pivoting around pivot 12, a bar 14 connected by shafts to one end of bar 13 and bottom plate 6, respectively, and a bar 15 connected by shafts to the other end of bar 13 and lower plate 2, respectively.

Furthermore pivot 12 is fixed to base 9 via a fixing member 16.

Tie bar 7, driving mechanism 10 and link mechanism 11 cooperate to configure a mechanism moving top and bottom die blocks 1 and 3 upward and downward.

A wired base material 17 is formed lengthy and also has an electronic component already packaged thereon and wired for example with a wire. Wired base material 17 is fed continuously from a wire bonder, a reel or the like (not shown) provided on a left hand, as seen in the figure, through a guide roller 18 and right and left, horizontally positioned pinch rollers 19 successively to a space provided between die set 5, i.e., between top and bottom die blocks 1 and 3.

Right and left pinch rollers 19 are fixed to base 9 via attachments 20 and 21.

Pinch rollers 19 transport wired base material 17, which has a minimum loop 22 required for transport.

The present die opening and closing mechanism operates, as described hereinafter.

Initially, as shown in Fig. 1A, driving mechanism 10 drives lower plate 2 to move it downward and also cause bars 15, 13, 14 to give way. This drives bottom plate 6 in a direction opposite lower plate 2 to move bottom plate 6 upward and also allows tie bar 7 to move upward upper plate 4 linked to bottom plate 6. Subsequently, lower plate 2 moves downward and upper plate 4 moves upward to completely open die set 5 of top and bottom die blocks 1 and 3.

Then, as shown in Fig. 1B, driving mechanism 10 drives lower plate 2 to move it upward and also cause bars 15, 13, 14 to extend. This drives bottom plate 6 in a direction opposite lower plate 2 to move bottom plate 6 downward and also allows tie bar 7 to move downward upper plate 4 linked to bottom plate 6. Subsequently, lower plate 2 moves upward and upper plate 4 moves downward to completely close die set 5.

The present die opening and closing mechanism is characterized in that, first of all, wired base material 17 is transported by a mechanism, i.e., right and left pinch rollers 19 fixed to base 9, independent from die set 5. This keeps wired base material 17 to have an invariable position, as seen in a direction of height, whether die set 5 is opened or closed. Wired base material 17 can thus have the Fig. 1A loop 22 minimized.

The present invention is also characterized in that a single driving mechanism 10 can drive top and bottom die blocks 1 and 3 simultaneously to open and close the die. Thus a simplified structure can be used so that when the die is opened, bottom and top die blocks 1 and 3 can be spaced ,as predetermined, as required for example for cleaning the die.

The present invention can thus minimize loop 22 of wired base material 17. It can thus provide a wire free of deformation and accommodate a lead frame large in thickness, and also provide a miniaturized resin seal apparatus.

Furthermore the present invention also ensures that when the die is opened, bottom and top die blocks 1 and 3 are spaced, as predetermined, as required.

In the above description the pair of link mechanisms 11 used for die set 5 of bottom and top die blocks 1 and 3 is formed of two link mechanisms arranged orthogonal to a direction in which wired base material 17 is transported. However, the present invention is not limited thereto and the pair of link mechanisms 11 may by formed of two link mechanisms arranged parallel to the direction in which wired base material 17 is transported.

Furthermore, a pair of link mechanisms structured by two link mechanisms arranged orthogonal to the direction followed to transport wired base material 17 and a pair of link mechanisms structured by two link mechanisms arranged parallel to the direction followed to transport wired base material 17 can also be used for a total of two pairs of link mechanisms to consider the total weight of die set 5, lower plate 2, upper plate 4, and bottom plate 6.

Furthermore while the embodiment uses a drive and transfer mechanism in the form of link mechanism 11, it may alternatively for example use a rack and pinion mechanism formed of a rack attached to pivot 12 and a pinion attached to lower plate 2 and bottom plate 6, respectively.

The present invention has also been described in an application to a tape for TAB or other similar, continuous, lengthy, wired base material. The present invention, however, is not limited thereto and if three die blocks form a die and the intermediate die is fixed to use a lead frame provided in the form of a strap the present invention can also be applied to provide a simplified die opening and closing mechanism.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A die opening and closing mechanism for use in a resin seal apparatus sealing with resin an electronic component attached to a wired base material (17), comprising:
a die set formed of opposite die blocks (1, 3);
a mechanism (7, 10, 11) moving each of said die blocks (1, 3) upward and downward; and
a mechanism (18, 19, 20, 21) transporting said wired base material (17) to a space provided between said die blocks (1, 3),
wherein said transporting mechanism (18, 19, 20, 21) is provided to be independent from said die set (5).

2. The die opening and closing mechanism of claim 1, wherein said transporting mechanism (18, 19, 20, 21) includes a mechanism (10) driving one of said die blocks (1, 3) in a predetermined direction and a mechanism (11) transferring to the other die block (1, 3) a driving force imparted by said driving mechanism (10) to one die block (1, 3), wherein said transferring mechanism (11) drives said other die block (1, 3) in a direction opposite a direction followed to drive said one die block (1, 3), to open and close said die set (5).

3. The die opening and closing mechanism of claim 1, wherein said transferring mechanism (11) is a link mechanism.

4. The die opening and closing mechanism of claim 1, wherein said wired base material (17) is a lengthy member continuously fed.

5. The die opening and closing mechanism of claim 1, wherein said wired base material (17) is a lead frame.

6. The die opening and closing mechanism of claim 1, wherein said wired base material (17) is a tape for TAB.

7. The die opening and closing mechanism of claim 1, wherein said transporting mechanism (18, 19, 20, 21) itself is positionally fixed.
